(19) Europäisches Patentamt / European Patent Office / Office européen des brevets

(11) **EP 2 385 604 A1**

(12) **EUROPÄISCHE PATENTANMELDUNG**

(43) Veröffentlichungstag:
**09.11.2011 Patentblatt 2011/45**

(51) Int Cl.:
*H02J 7/00* (2006.01)   *G01R 31/36* (2006.01)

(21) Anmeldenummer: **10162353.6**

(22) Anmeldetag: **07.05.2010**

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**
Benannte Erstreckungsstaaten:
**BA ME RS**

(71) Anmelder: **Brusa Elektronik AG**
**9466 Sennwald (CH)**

(72) Erfinder: **Krause, Axel**
**9650, Nesslau (CH)**

(74) Vertreter: **Rosenich, Paul**
**Patentbüro Paul Rosenich AG**
**BGZ**
**9497 Triesenberg (LI)**

(54) **Verfahren und Zellüberwachungseinheit zur Überwachung eines Akkumulators, zentrale Überwachungseinheit und Akkumulator**

(57) Es wird ein Verfahren zur Überwachung eines Akkumulators (1) mit mehreren Zellen (2, 2a..2n) angegeben, bei dem ein Parameter einer Zelle (2, 2a..2n) gemessen und an eine zentrale Überwachungseinheit (4) übermittelt wird. Erfindungsgemäss erfolgt die Übermittlung des Messwerts mit Hilfe eines pulsweitenmodulierten Signals. Weiterhin werden eine erfindungsgemässe Zellüberwachungseinheit (3, 3a..3n), eine erfindungsgemässe zentrale Überwachungseinheit (4) sowie ein erfindungsgemässer Akkumulator (1) zur Durchführung des erfindungsgemässen Verfahrens angegeben.

**Fig. 1**

EP 2 385 604 A1

**Beschreibung**

Die Erfindung betrifft ein Verfahren zur Überwachung eines Akkumulators mit mehreren Zellen, bei dem ein Parameter einer Zelle gemessen und an eine zentrale Überwachungseinheit übermittelt wird. Weiterhin betrifft die Erfindung eine Zellüberwachungseinheit zum Überwachen einer Zelle eines Akkumulators, welche eine Messeinrichtung zur Messung eines Parameters der Zelle sowie eine Sendeeinrichtung zur Übermittlung des Messwertes umfasst. Zudem betrifft die Erfindung eine zentrale Überwachungseinheit zur Überwachung eines Akkumulators mit mehreren Zellen, umfassend eine Empfangseinrichtung zum Empfang eines Messwertes eines Parameters einer Zelle. Schliesslich betrifft die Erfindung einen Akkumulator mit mehreren Zellen, welcher je Zelle eine Zellüberwachungseinheit umfasst beziehungsweise mit diesen verbunden ist.

Akkumulatoren bilden die Energieversorgung der überwiegenden Mehrzahl elektrisch betriebener, mobiler Geräte. Um eine geforderte Nennspannung, einen geforderten Strom und/oder eine geforderte Kapazität zu erreichen, werden zumeist mehrere galvanische Zellen zu einem Akkumulator verbaut.

Insbesondere bei Lithium-Ionen-Akkumulatoren und Lithium-Polymer-Akkumulatoren hat sich herausgestellt, dass die einzelnen Zellen bei der Entladung unterschiedliche Spannungslagen, beziehungsweise beim Laden mehrerer in Serie geschalteter Zellen ohne weitere Massnahmen unterschiedliche Ladezustände erreichen. Um ein für die Zelle schädliches Überladen oder Tiefentladen zu vermeiden und auch die Kapazität des Akkumulators optimal auszunutzen, werden die Zellen beim Laden einzeln kontrolliert. Dazu werden bei mehrzelligen Akkus für jede Zelle separate Anschlüsse bereitgestellt, die das individuelle Laden oder Entladen einer einzelnen Zelle gestatten. Das Ausgleichen dieser unterschiedlichen Zellspannungen beziehungsweise Ladezustände wird auch "Balancing" genannt.

Prinzipiell kann dieser Ausgleich durch gezieltes Entladen individueller Zellen, welche einen höheren Spannungspegel aufweisen, oder durch gezieltes Laden von Zellen, die einen zu niedrigen Spannungspegel aufweisen, erfolgen. Ersteres kann zum Beispiel mit Hilfe eines Widerstands erfolgen, über den die überschüssige Energie in Wärme umgewandelt wird. Beim gezielten Laden werden einzelne Zellen mit höherem Strom geladen oder es wird Energie von Zellen mit hohem Energieinhalt auf Zellen mit niedrigem Energieinhalt umgeladen.

Insbesondere bei Elektrokraftfahrzeugen - welche ja Akkumulatoren mit sehr hoher Kapazität aufweisen - haben sich im Laufe der Zeit zum Teil relativ komplexe Systeme herausgebildet, um einerseits die Kapazität des Akkumulators bestmöglich auszunutzen und um andererseits eine lange Lebensdauer zu gewährleisten. Beispielsweise ist dabei jeder Zelle eines Akkumulators eine Zellüberwachungseinheit zugeordnet, welche den Ladezustand, das Laden und das Entladen einer Zelle kontrolliert. Diese kommuniziert zumeist mit einer dem gesamten Akkumulator zugeordneten zentralen Überwachungseinheit, welche die Daten aller Zellüberwachungseinheiten sammelt und diese entsprechend ansteuert. Die zentrale Überwachungseinheit kommuniziert zumeist auch mit einer zentralen Fahrzeugsteuerung, welche zum Beispiel den Fahrer darüber informiert, für welche Wegstrecke der Akkumulator noch reicht. Selbstverständlich können dabei auch andere Parameter als die Zellspannung/Zellkapazität ermittelt beziehungsweise geregelt werden, beispielsweise die Zelltemperatur. Aus dem Stand der Technik sind einige Beispiele für solche Überwachungs-/Steuersysteme bekannt.

Beispielsweise offenbart die EP 0 814 556 A2 eine Balancing-Schaltung für einen Akkumulator mit mehreren in Serie geschalteten Zellen. Jeder Zelle ist dabei eine Kontrollschaltung zugeordnet, welche über einen Bus mit einer zentralen Steuerung verbunden ist. Die Kontrollschaltungen enthalten einen A/D-Wandler zur Erfassung der Zellspannung und der Zelltemperatur, einen damit verbundenen Mikroprozessor, eine damit verbundene Datenschnittstelle und einen Optokoppler zur Anbindung an den Bus. Weiterhin umfasst die Kontrollschaltung eine Referenzspannungsquelle. Der Mikroprozessor kann zudem ein pulsweitenmodulierten Signal (PWM-Signal) ausgeben, um eine Zelle über einen Widerstand definiert zu entladen.

Die DE 698 28 169 T2 offenbart eine weitere Balancing-Schaltung für einen Akkumulator mit mehreren in Serie geschalteten Zellen. Jeder Zelle ist wiederum eine Kontrollschaltung zugeordnet, welche eine Treiberschaltung zur definierten Entladung einer Zelle sowie einen A/D-Wandler zum Ermitteln der Zellspannung umfasst. Diese Einheiten sind über je einen Optokoppler mit einer zentralen Steuereinheit verbunden, welche die Messwerte der einzelnen Kontrollschaltungen empfängt und Spannungswerte für die einzelnen Zellen vorgibt. Der Zielspannungswert für eine Zelle wird dabei von der zentralen Steuerung mit Hilfe eines PWM-Signals an die einzelnen Kontrollschaltungen übertragen.

Die WO 2008/055505 A1 offenbart ein weiteres Batterie Management System, bei dem die Entladung einer spezifischen Zelle über einen Widerstand (einen "Shunt") erfolgt, welcher mit einem PWM-Signal angesteuert wird. Die der Zelle zugeordnete Entladeschaltung erhält dabei von einer zentralen Steuerung eine Zielspannung, welche in der Entladeschaltung dann in ein entsprechendes PWM-Signal umgewandelt wird.

Die WO 2006/108081 A2 offenbart eine Balancing Schaltung, bei dem die Spannungssignale mehrerer Zellen eines Akkumulators über einen Multiplexer an eine zentrale Messeinheit geführt werden. Weiterhin können die Zellen über einen mit einem PWM-Signal angesteuerten Shunt gezielt entladen werden.

Die US 6,873,134 B2 offenbart zudem ein Batterie Management System, bei dem lokale, einer Zelle eines Akkumulators zugeordnete Kontrollschaltungen über einen Bus mit einer zentralen Steuereinheit kommunizieren können und von dort eine Zielspannung für die jeweils betreffende Zelle erhalten.

Schliesslich zeigt die EP 2 085 784 A2 ein Batterie Management System für einen Akkumulator mit mehreren in Serie geschalteten Zellen, bei dem Daten im Zeitmultiplex übertragen werden können.

Nachteilig an den bekannten Systemen ist die zum Teil aufwändig gestaltete Kommunikation zwischen den den Zellen zugeordneten Zellüberwachungseinheiten und der dem Akkumulator zugeordneten zentralen Überwachungseinheit. Aufgabe der Erfindung ist es daher, ein verbessertes Verfahren und eine verbesserte Zellüberwachungseinheit zur Überwachung eines Akkumulators, sowie eine verbesserte zentrale Überwachungseinheit und einen verbesserten Akkumulator anzugeben. Insbesondere soll die Kommunikation zwischen den beteiligten Einheiten verbessert werden.

Erfindungsgemäss wird diese Aufgabe durch ein Verfahren der eingangs genannten Art gelöst, bei dem die Übermittlung eines Messwerts mit Hilfe eines pulsweitenmodulierten Signals erfolgt.

Die Aufgabe der Erfindung wird weiterhin durch eine Zellüberwachungseinheit der eingangs genannten Art gelöst, bei der die Sendeeinrichtung zur Übermittlung des Messwertes mit Hilfe eines pulsweitenmodulierten Signals eingerichtet ist.

Zudem wird die Aufgabe der Erfindung durch eine zentrale Überwachungseinheit der eingangs genannte Art gelöst, bei dem die Übermittlung des Messwerts mit Hilfe eines pulsweitenmodulierten Signals erfolgt.

Schliesslich wird die Aufgabe der Erfindung durch einen Akkumulator mit mehreren Zellen gelöst, welcher je Zelle eine erfindungsgemässe Zellüberwachungseinheit umfasst beziehungsweise mit dieser verbunden ist.

Mit Hilfe der eines pulsweitenmodulierten Signals (PWM-Signals) lassen sich Messwerte auch über weitere Strecken, beziehungsweise in einem hinsichtlich der elektromagnetischen Felder problematischen Umfeld sicher, das heisst weitgehend unverfälscht, übertragen. Dabei wird ein Messwert in ein Tastverhältnis eines Pulses mit konstanter Frequenz umgewandelt. Insbesondere gegenüber Systemen, welche Messwerte analog übertragen, beispielsweise über eine Stromschleife, stellt dies einen erheblichen Fortschritt dar, da analog übertragene Messwerte aufgrund der in einem Elektrokraftfahrzeug herrschenden elektromagnetischen Felder - beispielsweise verursacht durch den Antriebsmotor oder durch einen Wechselrichter - leicht verfälscht werden können. Aber auch gegenüber bekannten Systemen, bei denen Messwerte bereits digital übertragen werden, stellt die Erfindung einen Fortschritt dar, da ein Spannungs-PWM-Umsetzer, welcher in einer Zellüberwachungseinheit häufig ohnehin zum Ansteuern eines "Shunts" für das Balancing vorhanden ist, nun einen Doppelnutzen erfüllen kann. Erfindungsgemäss erhält dieser nicht nur Spannungssignale von einer zentralen Überwachungseinheit, die zur Erzeugung eines PWM-Signals für den Shunt herangezogen werden, sondern kann nun auch die Zellspannung in ein PWM-Signal umsetzten und solcherart zur zentralen Überwachungseinheit übermitteln. Selbstverständlich können für diese Aufgabe auch zwei getrennte PMW-Umsetzer verwendet werden.

Vorteilhafte Ausgestaltungen und Weiterbildungen der Erfindung ergeben sich nun aus den Unteransprüchen sowie aus der Beschreibung in Zusammenschau mit den Figuren der Zeichnung bzw. sind durch sie geoffenbart.

Vorteilhaft ist es, wenn die von den einzelnen Zellen stammenden pulsweitenmodulierten Signale synchron übermittelt und summiert werden. Auf diese Weise können die Messwerte aller Zellüberwachungseinheiten auf einmal, das heisst während einer einzigen Messwertübertragung, zur zentralen Überwachungseinheit übermittelt werden. Das Senden der Messwerte erfolgt also besonders schnell, ohne dass dafür - wie beim sequentiellen Senden von Messwerten - relativ hohe Taktfrequenzen für die Datenübermittlung nötig wären.

Vorteilhaft ist es in diesem Zusammenhang, wenn eine Stufe in dem durch die Summierung entstandenen treppenförmigen Signal in der zentralen Überwachungseinheit als Messwert einer Zelle interpretiert und der Messwert aus dem Summensignal isoliert wird. Wenn bekannt ist, wie hoch eine durch einen Messwert verursachte Stufe in dem treppenförmigen Summensignal ist, dann kann aus der Anordnung und Höhe der Stufen auf die Höhe der Messwerte und deren Verteilung geschlossen werden. Aus dem Summensignal kann auch ein einzelner Messwert isoliert werden.

Besonders vorteilhaft ist es, wenn die erste und/oder letzte Stufe in dem durch die Summierung entstandenem treppenförmigen Signal in der zentralen Überwachungseinheit als Extremwert des gemessenen Parameters innerhalb des Akkumulators interpretiert und der Messwert aus dem Summensignal isoliert wird. Die erste und die letzte Stufe in dem Summensignal entsprechen den im Akkumulator auftretenden Extremwerten. Wird als Messparameter beispielsweise die Zellspannung vorgesehen, dann entsprechen die erste und die letzte Stufe der niedrigsten beziehungsweise höchsten Zellspannung innerhalb des Akkumulators. Mit dieser Variante der Erfindung können also sehr rasch innerhalb eines Akkumulators auftretende Extremwerte festgestellt werden.

Vorteilhaft ist, wenn in der zentralen Überwachungseinheit für die Isolation eines Messwertes detektiert wird, ob das treppenförmige Signal einen zwischen zwei Stufen vorgegeben Pegelwert passiert. Wenn die Höhe der durch einen Messwert verursachten Stufe bekannt ist, dann kann ein Pegelwert zwischen zwei horizontalen (wenn die Zeit auf der horizontalen Achse aufgetragen ist) beziehungsweise vertikalen (wenn die Zeit auf der vertikalen Achse aufgetragen ist) Abschnitten der Stufen gesetzt werden und abgewartet werden, bis das Summensignal diesen Pegelwert passiert. Der Zeitpunkt des Passierens gibt das Tastverhältnis des diesem Messwert zugeordneten PWM-Signals und damit den Messwert selbst an.

Besonders vorteilhaft ist auch eine Variante des erfindungsgemässen Verfahrens, bei der zeitlich nacheinander jeweils ein Messwert individuell an die zentrale Überwachungseinheit übermittelt wird. Wenn die durch die einzelnen Messwerte verursachten Stufen alle dieselbe Höhe haben, dann ist zwar eine simultane Übermittlung aller Messwerte möglich, jedoch kann ein bestimmter Messwert nicht einer bestimmten Zelle zugeordnet werden. Bei dieser Variante der Erfindung wird aber sequentiell ein Messwert individuell übertragen, sodass in der zentralen Überwachungseinheit auch bekannt ist, welcher Messwert konkret welcher Zelle zugeordnet ist.

In diesem Zusammenhang ist es vorteilhaft, wenn der individuell an die zentrale Überwachungseinheit übermittelte Messwert parallel zum Summensignal übermittelt wird. Bei dieser Variante der Erfindung werden parallel zum individuell übertragenen Messwert alle übrigen Messwerte in Form eines Summensignals übertragen, sodass bei jeder Messwertübertragung zusätzlich zu einem individuellen Messwert die in einem Akkumulator auftretenden Extremwerte festgestellt werden können.

In diesem Zusammenhang ist es zudem von Vorteil, wenn der individuell an die zentrale Überwachungseinheit übermittelte Messwert aus der Summierung ausgenommen wird. Bei dieser Variante der Erfindung wird der individuell übermittelte Messwert aus der Summierung ausgenommen, um eine redundante Übermittlung von Messwerten zu vermeiden.

Günstig ist es, wenn als Messwert die Abweichung des Zellparameters von einem je Zelle vorgesehen Referenzwert herangezogen wird. Um den Messwert mit möglichst guter Auflösung ermitteln zu können, wird bei dieser Variante der Erfindung eine Abweichung des Zellparameters von einem Referenzwert übermittelt. Auf diese Weise kann zum Beispiel ein ohnehin immer oder zumindest häufig vorhandener "Offset" abgezogen werden. Wird beispielsweise die Zelltemperatur als Zellparameter herangezogen, so kann z.B. die Abweichung der Temperatur von 20°C als Messwert übermittelt werden, da 20° die Norm darstellt und Werte unter -20° und +80° eher selten auftreten dürften. Der solcherart auf $\Delta T=100°C$ beschränkte Bereich kann somit mit guter Messwertauflösung übermittelt werden. Messwerte ausserhalb des Bereichs werden als Messwertüberlauf übermittelt.

Vorteilhaft ist es auch, wenn

- für die Erfassung von Messwerten verwendete und je Zelle vorgesehene Referenzwerte benachbarter Zellen periodisch wiederkehrend miteinander verglichen werden, und
- eine Fehlermeldung ausgegeben wird, wenn die Abweichung einen vorgebbaren Grenzwert überschreitet.

Häufig werden für die Ermittlung von Messwerten Referenzwerte benötigt. Beispielsweise kann in einer Zellüberwachungseinheit eine Referenzspannungsquelle vorgesehen sein, wenn die Zellspannung als Messparameter herangezogen wird. Um eine (unerwünschte) Veränderung dieses Spannungsnormals erkennen zu können, wird der Referenzwert einer Zellüberwachungseinheit mit einem Referenzwert einer anderen Zellüberwachungseinheit verglichen. Tritt eine unerwartet hohe Abweichung auf, so ist vermutlich eine der beiden Referenznormale defekt. "Benachbart" bedeutet in diesem Zusammenhang nicht zwingend örtlich benachbart sondern "elektrisch" benachbart. Beispielsweise sind zwei elektrisch miteinander verbundene Zellen "elektrisch" benachbart, müssen aber nicht in unmittelbarer örtlicher Nähe angeordnet sein.

An dieser Stelle wird darauf hingewiesen, dass die oben genannte Variante der Erfindung auch ohne die zu den übrigen Varianten genannten Merkmalen vorteilhaft sein und damit die Basis einer unabhängigen Erfindung bilden kann.

Günstig ist es, wenn als Parameter die Spannung und/oder die Temperatur der Zelle vorgesehen ist. Diese beiden Parameter sind besonders aussagekräftig für eine Zelle. Beispielsweise kann durch Überwachen der Zellspannung ein Überladen oder Tiefentladen derselben vermieden werden. Gleichermassen kann durch Überwachung der Temperatur der Zelle ein Betrieb ausserhalb eines zulässigen oder optimalen Betriebsbereichs verhindert werden.

Besonders vorteilhaft ist es, wenn die gemessene Spannung und die gemessene Temperatur dazu herangezogen werden, eine mit den Klemmen einer Zelle verbundene und an die Zelle thermisch gekoppelte Heizung bei Überschreiten eines Grenzwertes für die Zellspannung oder bei Unterschreiten eines Grenzwertes für die Zelltemperatur zu aktivieren. Bei dieser Variante wird ein parallel zur Zelle angeordneter Widerstand ("Shunt") nicht nur dazu verwendet, eine Zelle bei Überspannung gezielt zu entladen, also das Balancing zu bewerkstelligen, sondern auch dazu, um die Zelle bei zu geringer Temperatur zu erwärmen. Eine Zelle kann bei zu geringer Temperatur in der Regel nur eine reduzierte Leistung abgeben, weswegen es unter Umständen sinnvoll ist, die Zelle vor dem Einsatz auf Betriebstemperatur zu bringen. Bei dieser Variante der Erfindung wird dazu der häufig ohnehin für das Balancing vorhandene Shunt verwendet, der solcherart einen Doppelnutzen erbringt. Um eine optimale Heizwirkung zu erzielen sollte die thermische Kopplung zwischen Zelle und Shunt entsprechend ausgeführt sein, beispielsweise unter Zuhilfenahme von Wärmeleitpasten, einer Luftumwälzung und dergleichen.

An dieser Stelle wird darauf hingewiesen, dass die oben genannte Variante der Erfindung auch ohne die zu den übrigen Varianten genannten Merkmalen vorteilhaft sein und damit die Basis einer unabhängigen Erfindung bilden kann.

Vorteilhaft ist es bei obiger Variante, wenn die Heizung so geregelt wird, dass die Zellspannung und/oder die Zelltemperatur einen vorgegebenen Sollwert oder einen Sollbereich einhält. Bei dieser Variante der Erfindung werden also nicht nur Grenzwerte im Sinne einer maximalen Zellspannung und/oder einer minimalen Zelltemperatur vorgegeben, sondern es wird ein Sollwert oder ein Sollbereich für einen Zellparameter vorgegeben. Das heißt es wird beispielsweise eine Soll-Zellspannung beziehungsweise eine minimale und eine maximale Zellspannung und/oder eine Soll-Zelltemperatur beziehungsweise eine minimale und eine maximale Zelltemperatur vorgegeben.

Vorteilhaft ist es bei einer Regelung eines Zellparameters auch, wenn die Übermittlung eines Sollwerts mit Hilfe eines pulsweitenmodulierten Signals erfolgt. Bei dieser Variante der Erfindung wird ein Sollwert von der zentralen Überwachungseinheit mit Hilfe eines PWM-Signals an die Zellüberwachungseinheit übermittelt, analog zur Messwertübermittlung von einer Zellüberwachungseinheit zu der zentralen Überwachungseinheit. Vorteilhaft kann so die für die Messwertübertragung ohnehin vorhandene Struktur (Messwertumformer, Datenleitungen, usw.) auch für die Übermittlung eines Sollwerts genutzt werden. Vorteilhaft ist dabei auch, dass ein Sollwert an mehrere Zellüberwachungseinheiten gleichzeitig gesendet werden kann und dieser dort lokal zur Ermittlung eines Stellwertes verwendet wird, die eigentliche Regelung also in der Zellüberwachungseinheit stattfindet. Dies steht im Gegensatz zu den aus dem Stand der Technik bekannten Lösungen, bei denen die zentrale Überwachungseinheit für jede Zellüberwachungseinheit gesonderte Stellwerte ermittelt und in Folge individuell übermittelt, die eigentliche Regelung also in der zentralen Überwachungseinheit erfolgt. Letzteres erfordert eine vergleichsweise komplexe Kommunikation zwischen der zentralen Überwachungseinheit und den Zellüberwachungseinheiten, wohingegen bei der erfindungsgemässen Variante mit relativ geringen Datenmengen das Auslangen für eine Regelung eines Zellparameters, insbesondere der Zellspannung und/oder der Zelltemperatur, gefunden werden kann.

Zudem wird angemerkt, dass sich die zum erfindungsgemässen Verfahren genannten Varianten und die daraus resultierenden Vorteile gleichermassen auf die erfindungsgemässe Zellüberwachungseinheit, die erfindungsgemässen zentrale Überwachungseinheit und den erfindungsgemässen Akkumulator beziehen und umgekehrt.

Schliesslich wird angemerkt, dass sich das erfindungsgemässe Verfahren beziehungsweise die erfindungsgemässe Zellüberwachungseinheit sowie die erfindungsgemässen zentrale Überwachungseinheit in Software und/oder in Hardware realisieren lässt. Wird die Erfindung in Software realisiert, dann führt ein Programm, welches in einem Mikroprozessor beziehungsweise Mikrocontroller abläuft, die erfindungsgemässen Schritte aus. Selbstverständlich kann die Erfindung auch bloss in Hardware umgesetzt werden, beispielsweise mit einem ASIC (Application Specific Integrated Circuit). Letzterer kann aber auch einen Prozessor beinhalten. Schliesslich kann ein Teil der Erfindung in Software, ein anderer Teil in Hardware umgesetzt werden.

Die obigen Ausgestaltungen und Weiterbildungen der Erfindung lassen sich auf beliebige Art und Weise kombinieren.

Die vorliegende Erfindung wird nachfolgend anhand der in den schematischen Figuren der Zeichnung angegebenen Ausführungsbeispiele näher erläutert. Es zeigen dabei:

Fig. 1    schematisch eine Übersichtsdarstellung eines ersten erfindungsgemässen Akkumulators;

Fig. 2    eine Detaildarstellung einer ersten erfindungsgemässen Zellüberwachungseinheit;

Fig. 3    eine Detaildarstellung einer ersten zentralen Überwachungseinheit;

Fig. 4    den zeitlichen Verlauf verschiedener in einem erfindungsgemässen Akkumulator auftretenden Signale, insbesondere ein aus einzelnen Messwerten gebildetes Summensignal;

Fig. 5    schematisch eine Übersichtsdarstellung einer zweiten Variante eines erfindungsgemässen Akkumulators;

Fig. 6    eine Detaildarstellung einer zweiten erfindungsgemässen Zellüberwachungseinheit;

Fig. 7    eine Detaildarstellung einer zweiten zentralen Überwachungseinheit;

Fig. 8    schematisch eine Übersichtsdarstellung einer weiteren Variante eines erfindungsgemässen Akkumulators;

Fig. 9    eine Detaildarstellung einer weiteren zentralen Überwachungseinheit;

Fig. 10   den zeitlichen Verlauf verschiedener in dem erfindungsgemässen Akkumulator gemäss Fig. 8 auftretenden Signale;

Fig. 11   eine beispielhafte Schaltung zur Überwachung einer Referenzquelle einer Zellüberwachungseinheit und

Fig. 12   den zeitlichen Verlauf verschiedener in der Schaltung gemäss Fig. 11 auftretenden Signale.

In den Figuren der Zeichnung sind gleiche und ähnliche Teile mit gleichen Bezugszeichen und funktionsähnliche Elemente und Merkmale - sofern nichts Anderes ausgeführt ist - mit gleichen Bezugszeichen aber unterschiedlichen Indizes versehen.

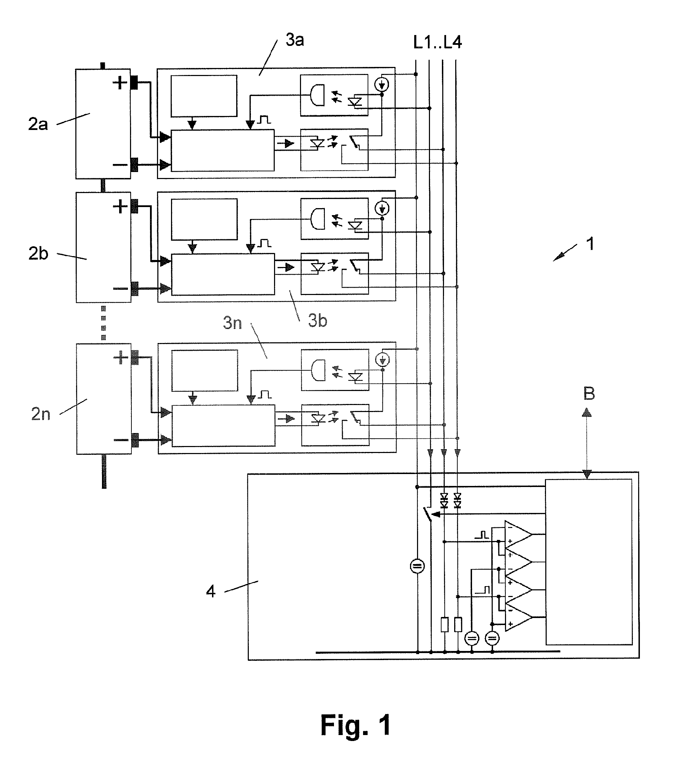

Fig. 1 zeigt eine Batterie 1, umfassend mehrere Zellen 2a..2n mit damit verbundenen und gleichartig aufgebauten Zellüberwachungseinheiten 3a..3n sowie eine zentrale Überwachungseinheit 4. Die Zellüberwachungseinheiten 3a..3n sind über Signalleitungen L1..L4 mit der zentralen Überwachungseinheit 4 verbunden. Die zentrale Überwachungseinheit 4 ist über einen Datenbus B schliesslich noch mit weiteren, nicht dargestellten Steuereinheiten verbunden.

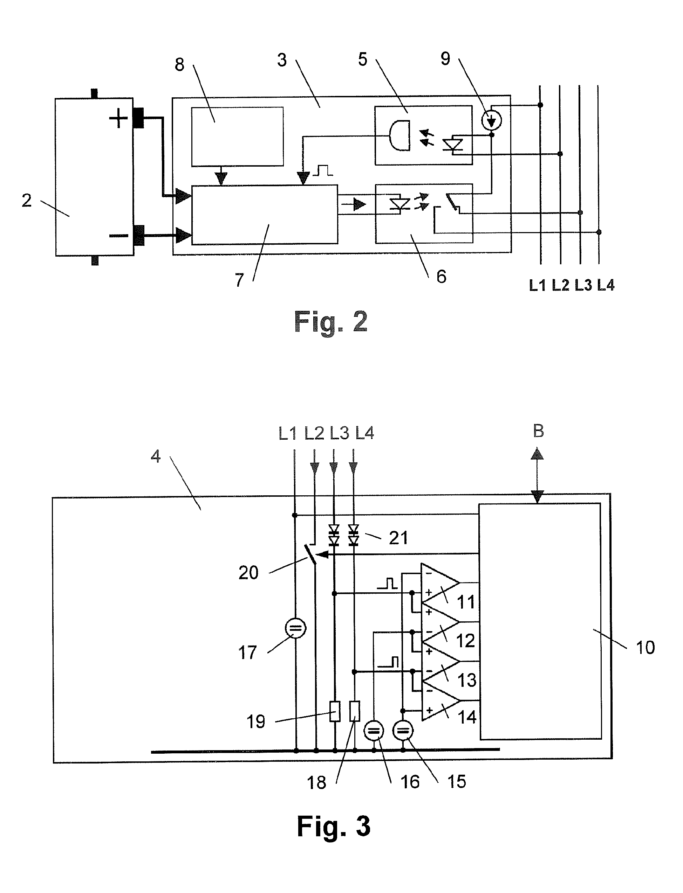

Fig. 2 zeigt eine Zellüberwachungseinheit 3 aus Fig. 1, welche an eine Zelle 2 angeschlossen ist, im Detail. Die Zellüberwachungseinheit 3 umfasst einen eingangsseitigen Optokoppler 5 und einen ausgangsseitigen Optokoppler 6. Diese sind zwar vorteilhaft für die Erfindung aber keineswegs zwingend, da der Anschluss der Zellüberwachungseinheit 3 an die Signalleitungen L1..L4 auch über andere Weise erfolgen kann, beispielsweise über Trenntransformatoren. Die Zellüberwachungseinheit 3 umfasst weiterhin einen Messwertumformer 7 und eine Referenzquelle 8. Der Messwertumformer 7 ist mit dem eingangsseitigen Optokoppler 5, dem ausgangsseitigen Optokoppler 6 sowie der Referenzquelle 8 verbunden. Eingangsseitig ist schliesslich noch eine Stromquelle 9 angeordnet.

Fig. 3 zeigt nun die zentrale Überwachungseinheit 4 aus Fig. 1 im Detail. Diese umfasst einen Mikrocontroller 10, mehrere Komparatoren 11..14, drei Spannungsquellen 15..17, zwei Widerstände 18, 19, einen Schalter 20 sowie Dioden 21.

Die Funktion des erfindungsgemässen Akkumulators 1 wird nun anhand der Figuren 1 bis 4 näher erläutert:

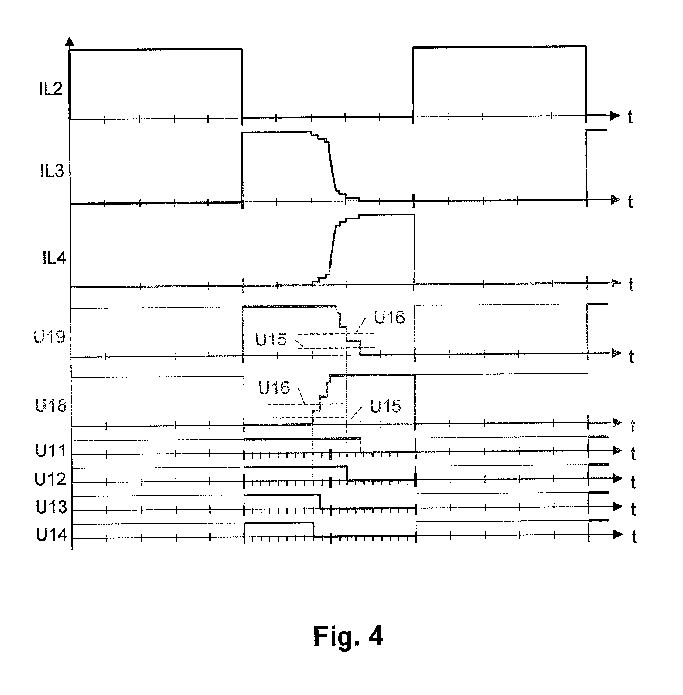

Über die zweite Signalleitung L2 wird von der zentralen Überwachungseinheit 4 eine Referenzpuls-Folge mit definierter Pulsdauer (z.B. 0,5ms) und definierter Frequenz (z.B. 1kHz) an alle Zellüberwachungseinheiten 3a..3n gesendet. Dazu wird der Schalter 20 vom Mikrocontroller 10 in entsprechender Weise periodisch angesteuert. Beim Schliessen des Schalters 20 wird der Stromkreis zwischen der Spannungsquelle 17, den Stromquellen 9, den Optokopplern 5 und dem Masseanschluss geschlossen. Auf diese Weise wird das dem Schalter 20 aufgeprägte Signal in die Zellüberwachungseinheiten 3a..3n gesendet und dient dort als Referenzpuls für die Messwertumformer 7. In Fig. 4 ist dazu der Strom in der zweiten Signalleitung L2 gezeigt, welcher ein zentrales Referenz- oder Taktsignal darstellt.

Jede Zellüberwachungseinheit 3a..3n erzeugt mithilfe der Referenzquelle 8 und dem Referenzpuls einen zum Referenzpuls synchronen Mess-Impuls, dessen Dauer linear vom Messwert abhängt. Im vorliegenden Beispiel ist als Messparameter die Zellspannung und als Referenzquelle 8 entsprechend eine Referenzspannungsquelle vorgesehen. Analog könnte als Messwert beispielsweise auch die Zelltemperatur und als Referenzquelle 8 eine Referenztemperaturquelle vorgesehen sein. Häufig wird eine Temperatur von einem Temperatursensor in einen Widerstandswert oder eine Spannung umgewandelt. Als Referenzquelle 8 kann dann entsprechend ein Referenzwiderstand oder wiederum eine Referenzspannungsquelle oder eine Referenz-Stromquelle dienen.

Mit Hilfe des Messwertumformers 7 wird im vorliegenden Beispiel aus einem Spannungssignal ein pulsweitenmoduliertes Signal (PWM-Signal) generiert. Beispielsweise wird eine steigende/fallende Flanke eines periodischen Signals mit konstanter Frequenz um 0,25ms pro Volt Abweichung des Messwerts von einem Referenzwert von 2V verschoben. Als Messwert wird also die Abweichung eines Zellparameters von einem je Zelle vorgesehen Referenzwert herangezogen. Dieser Messimpuls erfolgt vorwiegend in der Pause zwischen zwei Referenzpulsen.

Über den ausgangsseitigen Optokoppler 6 wird sodann abwechselnd die erste Leitung L1 mit der dritten Leitung L3 oder die erste Leitung L1 mit der vierten Leitung L4 verbunden. Wegen der Stromquelle 9 wird über die Widerstände 18 und 19 ein Spannungssignal in der zentralen Überwachungseinheit 4 erzeugt. Werden mehrere Optokoppler 6 gleichzeitig betätigt, dann werden die Stromquellen 9 parallel geschalten und erzeugen so einen Summenstrom, welcher sich in einem erhöhten Spannungswert an den Widerständen 18 und 19 äussert. In der Regel sind die Spannungen der Zellen 2a..2n unterschiedlich, sodass die Optokoppler 6 wegen des jeweils individuellen PWM-Signals zu verschiedenen Zeitpunkten aktiviert werden. Somit resultiert durch die Summierung der PWM-Signale ein treppenförmiges Summensignal.

In Fig. 4 sind dazu die Ströme IL3, IL4 in der dritten Signalleitung L3 und in der vierten Signalleitung L4 gezeigt, welche jeweils ein aus den einzelnen Messwerten gebildetes Summensignal zeigen. Das Summensignal an der Leitung L3 ist dabei das "quasi-inverse" Signal des Signals an der Leitung L4.

Die Übermittlung eines Messwerts erfolgt also mit Hilfe eines pulsweitenmodulierten Signals, wobei die von den einzelnen Zellen 2a..2n stammenden pulsweitenmodulierten Signale synchron übermittelt und summiert werden.

Im vorliegenden Fall wird angenommen, dass alle Stromquellen 8 denselben Strom liefern. Die einzelnen Stufen sind daher - vorausgesetzt jede Stromquelle wird zu einem anderen Zeitpunkt aktiviert - gleich hoch. Denkbar ist aber auch, dass jede Stromquelle 8 einen anderen Strom liefert, sodass über die Höhe der entstandenen Stufe die konkret sendende Zellüberwachungseinheit 3a..3n ermittelt werden kann. Besonders vorteilhaft ist es dabei, wenn die Ströme binär kodiert sind, sodass beispielsweise der Strom der Zellüberwachungseinheit 3b doppelt so gross ist wie der Strom der Zellüberwachungseinheit 3a, der darauf folgende Strom viermal so gross ist usw. Die konkret sendende Zellüberwachungseinheit 3a..3n kann aber auch auf andere Weise ermittelt werden, wie nachfolgend noch erläutert wird.

Die Spannungsverläufe U19 und U18 in Fig. 4 zeigen nun die aufgrund des eingeprägten Stroms an den Wiederständen 19 und 18 abfallende Spannung. Dabei zeigt U18 den quasi vergrösserten Verlauf von IL4 bei kleinen Stromwerten, U19 den quasi vergrösserten Verlauf von IL3 bei kleinen Stromwerten. Ausserdem ist zu sehen, dass die Verläufe beschnitten sind. Dies wird durch die Dioden 21 bewirkt, welche die Spannung an den Widerständen 18 und 19 wegen der exponentiellen Strom-Spannungs-Kennlinie der Dioden 21 begrenzen.

Mit Hilfe der Spannungsquelle 15 wird an die Komparatoren 11 und 14 ein Spannungsschwellwert beziehungsweise ein Spannungspegel U15 angelegt, welche der halben Spannung, der von einer Stromquelle 8 verursachten Spannung entspricht. Analog wird mit Hilfe der Spannungsquelle 16 an die Komparatoren 12 und 13 ein Spannungsschwellwert beziehungsweise ein Spannungspegel U16 angelegt, welche der eineinhalbfachen Spannung, der von einer Stromquelle 8 verursachten Spannung entspricht.

Überschreitet die Spannung U18 nun den ersten Spannungspegel, so erzeugt der Komparator 14 eine fallende Flanke in seiner Ausgangspannung U14. Das Spannungssignal U14 entspricht somit dem PWM-Signal jener Zellüberwachungseinheit 3a..3n, welche den niedrigsten Messwert innerhalb des Akkumulators 1 ermittelt hat. Überschreitet die Spannung U18 nun den zweiten Spannungspegel, so erzeugt der Komparator 13 eine fallende Flanke in seiner Ausgangspannung U13. Das Spannungssignal U13 entspricht somit dem PWM-Signal jener Zellüberwachungseinheit 3a..3n, welche den zweit-niedrigsten Messwert innerhalb des Akkumulators 1 ermittelt hat.

Unterschreitet die Spannung U19 den zweiten Spannungspegel U16, so erzeugt der Komparator 12 eine fallende Flanke in seiner Ausgangspannung U12. Das Spannungssignal U12 entspricht somit dem PWM-Signal jener Zellüberwachungseinheit 3a..3n, welche den zweit-höchsten Messwert innerhalb des Akkumulators 1 ermittelt hat. Unterschreitet die Spannung U19 nun den ersten Spannungspegel U15, so erzeugt der Komparator 11 eine fallende Flanke in seiner Ausgangspannung U11. Das Spannungssignal U11 entspricht somit dem PWM-Signal jener Zellüberwachungseinheit 3a..3n, welche den höchsten Messwert innerhalb des Akkumulators 1 ermittelt hat.

Vorteilhaft können so innerhalb eines Messzyklus simultan der höchste, der zweit-höchste, der niedrigste und der zweitniedrigste Messwert von der zentralen Überwachungseinheit 4 erfasst werden.

Eine Stufe in dem durch die Summierung entstandenen treppenförmigen Signal IL3, IL4, U18, U19 wird in der zentralen Überwachungseinheit also als Messwert einer Zelle 2a..2n interpretiert, und es wird zumindest ein Messwert aus dem Summensignal IL3, IL4, U18, U19 isoliert. Die erste und/oder die letzte Stufe in dem durch die Summierung entstandenem treppenförmigen Signal IL3, IL4, U18, U19 wird in der zentralen Überwachungseinheit 4 zudem als Extremwert des gemessenen Parameters innerhalb des Akkumulators 1 interpretiert, und es wird der betreffende Messwert aus dem Summensignal IL3, IL4, U18, U19 isoliert. Dazu wird in der zentralen Überwachungseinheit 4 detektiert, ob das treppenförmige Signal U18, U19 einen zwischen zwei Stufen vorgegeben Pegelwert U15, U16 passiert.

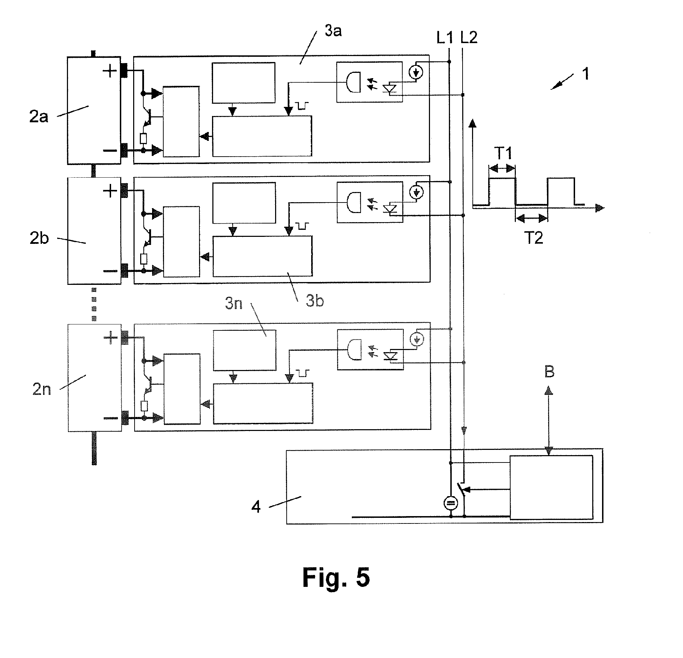

Fig. 5 zeigt nun eine weitere Variante des erfindungsgemässen Akkumulators 1. Dieser ist sehr ähnlich zu dem in Fig. 1 dargestellten Akkumulator 1 und umfasst mehrere Zellen 2a..2n mit damit verbundenen und gleichartig aufgebauten Zellüberwachungseinheiten 3a..3n sowie einer zentralen Überwachungseinheit 4. Die Zellüberwachungseinheiten 3a..3n sind über Signalleitungen L1, L2 mit der zentralen Überwachungseinheit 4 verbunden. Die zentrale Überwachungseinheit 4 ist über einen Datenbus B schliesslich noch mit weiteren, nicht dargestellten Steuereinheiten verbunden.

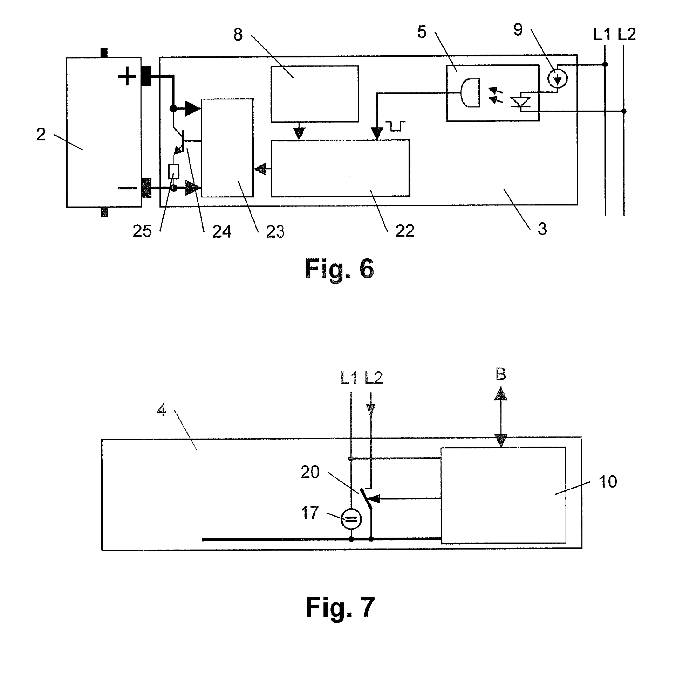

In Fig. 6 ist eine Zellüberwachungseinheit 3 aus Fig. 5 im Detail dargestellt. Die Zellüberwachungseinheit 3 umfasst einen eingangsseitigen Optokoppler 5, einen Stellwertumformer 22, eine Referenzquelle 8, einen Zellregler 23, einen Transistor 24 und einen Widerstand 25. Eingangsseitig ist schliesslich noch eine Stromquelle 9 angeordnet. Der Stellwertumformer 22 ist mit dem eingangsseitigen Optokoppler 5, der Referenzquelle 8 sowie mit dem Zellregler 23 verbunden. Der Stellwertumformer 22 ist mit dem Zellregler 23 verbunden. Dieser ist schliesslich mit der Zelle 2 verbunden und steuert eine zwischen den Anschlüssen der Zelle 2 angeordnete Serienschaltung aus dem Transistor 24 und dem Widerstand 25 an.

Der eingangsseitige Optokoppler 5 ist zwar wie schon bei dem in Fig. 1 dargestellten Akkumulator 1 vorteilhaft für die Erfindung aber keineswegs zwingend, da der Anschluss der Zellüberwachungseinheit 3 an die Signalleitungen L1..L2 auch über andere Weise erfolgen kann, beispielsweise über Trenntransformatoren, Eingangsverstärker und dergleichen.

Fig. 7 zeigt nun die zentrale Überwachungseinheit 4 aus Fig. 5 im Detail. Diese umfasst einen Mikrokontroller 10, eine Spannungsquelle 17 und einen Schalter 20.

Die Funktion dieser Variante der Erfindung wird nun anhand des in den Figuren 5 bis 7 dargestellten Akkumulators 1 näher erläutert:

Ziel dieser Schaltungsvariante ist es, Unterschiede zwischen den einzelnen Zellen 2a..2n hinsichtlich eines bestimmten Parameters auszugleichen. Im vorliegenden Fall sollen die einzelnen Zellspannungen aneinander angeglichen werden, man spricht auch von "Balancing". Selbstverständlich könnten mit der vorliegenden Variante der Erfindung auch andere Zellparameter aneinander angeglichen werden, beispielsweise die Zelltemperatur.

Vom Mikrocontroller 10 wird dazu ein Sollwert vorgegeben, und zwar in Form eines PWM-Signals durch Variation der Zeiten T1 und T2. Dazu wird der Schalter 20 entsprechend getaktet und das Signal solcherart über die Leitungen L1 und L2 an alle Zellüberwachungseinheiten 3a..3n weitergeleitet. Über den eingangsseitigen Optokoppler 5 wird das Stellsignal an den Stellwertumformer 22 weitergeleitet, welcher mit Hilfe der Referenzquelle 8 (im vorliegenden Beispiel eine Referenzspannungsquelle) aus dem PWM-Signal ein Stellsignal in Form eines Pegels (im vorliegenden Beispiel einen Spannungspegel) erzeugt. Dieser Spannungspegel wird als Sollwert in den Zellregler 23 eingegeben, welcher diesen mit den an den Klemmen der Zelle 2 gemessenen Spannung vergleicht und den Transistor 24 aktiviert, wenn die Zellspannung zu hoch ist. Über den Widerstand 25 wird die überschüssige Zellspannung abgebaut und in Wärme umgewandelt.

In einer besonders vorteilhaften Variante der Erfindung kann zudem ein Sollwert für eine Zelltemperatur vorgegeben werden, der analog zum Sollwert für die Zellspannung mit Hilfe eines PWM-Signals übertragen wird. Ist die Zelltemperatur zu niedrig, dann wird ebenfalls der Transistor 24 aktiviert, um die Zelle 2 aufzuheizen. Dabei sollte für einen guten Wärmeübergang zwischen Zelle 2 und Widerstand 25 gesorgt werden.

Es wird also die gemessene Spannung und die gemessene Temperatur dazu herangezogen, eine mit den Klemmen einer Zelle 2 verbundene und an die Zelle 2 thermisch gekoppelte Heizung (hier in Form des Widerstands 25) bei Überschreiten eines Grenzwertes für die Zellspannung oder bei Unterschreiten eines Grenzwertes für die Zelltemperatur zu aktivieren.

An dieser Stelle wird angemerkt, dass die in der Fig. 1 dargestellte Variante der Erfindung und die in Fig. 5 dargestellte Variante auch miteinander kombiniert werden können, sodass ein System vorliegt, dass die Funktionalität der in der Fig. 1 dargestellten Schaltung mit der Funktionalität der in der Fig. 5 dargestellten Schaltung vereint. Selbstverständlich können bestimmte Funktionen auch gemeinsam genutzt werden. Direkt offensichtlich ist dies beispielsweise beim eingangsseitigen Optokoppler 5, der Referenzquelle 8, dem Mikrocontroller 10 usw. Aber auch die Funktion des Messwertumformers 7 und des Stellwertumformers 22 kann von ein und demselben Baustein übernommen werden, beispielsweise einem Spannungs-PWM-Umformer, dem mal ein Messwert, mal ein Stellwert als Eingangssignal zugeführt wird.

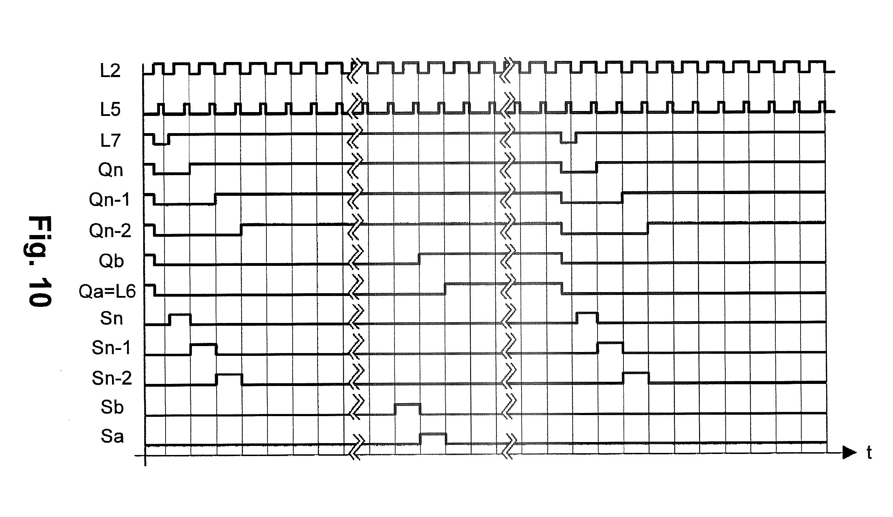

Überhaupt wird angemerkt dass die in den Figuren 1 bis 11 dargestellte Unterteilung in verschiedene Einheiten nicht zwingend physikalisch in der gezeigten Form umgesetzt ist. Selbstverständlich können mehrere funktionale Blöcke in einem Bauteil zusammengefasst sein. Beispielsweise kann die Zellüberwachungseinheit 3 im Wesentlichen aus einem einzigen

Baustein aufgebaut sein, beispielsweise aus einem Mikrocontroller, bei dem die einzelnen funktionalen Blöcke durch Schaltungsteile des Mikrocontrollers und/oder entsprechende Software-Routinen gebildet ist. Auch eine Realsierung in Form eines ASICs (Application Specific Integrated Circuit) ist möglich.

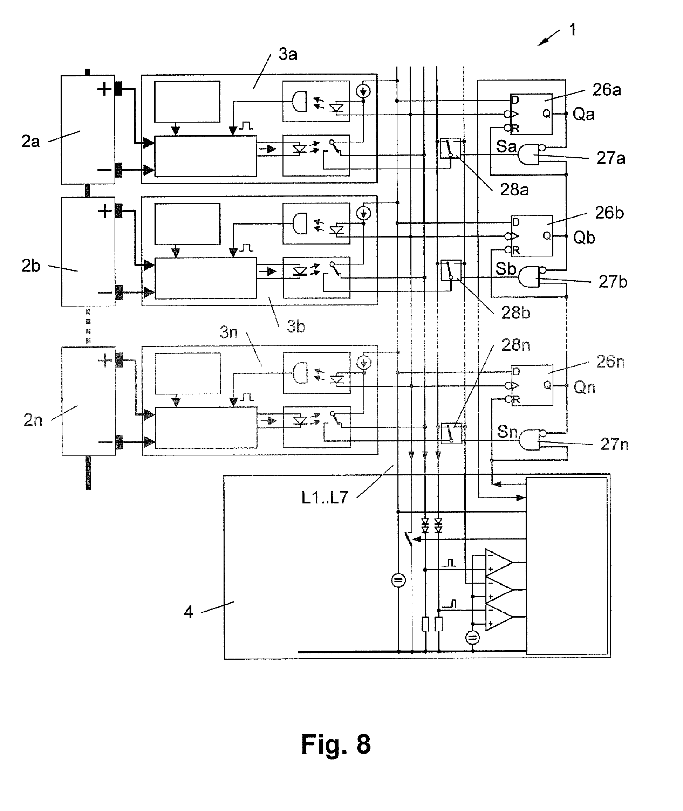

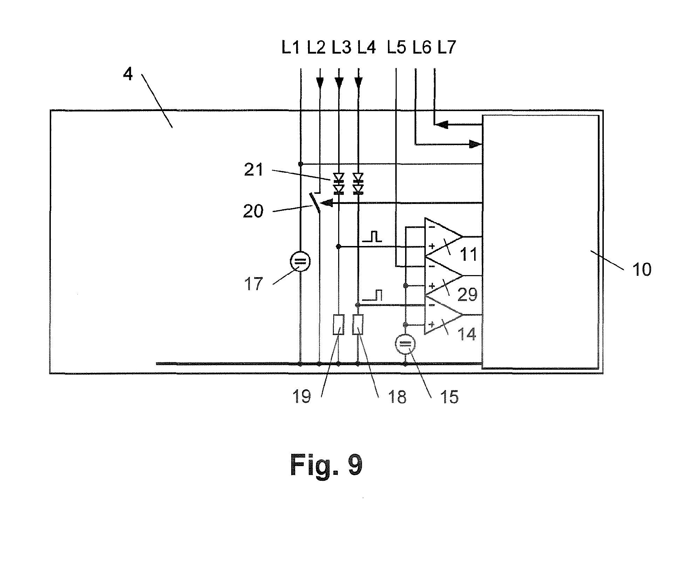

Fig. 8 zeigt nun eine weitere Variante des erfindungsgemässen Akkumulators 1, welcher dem in Fig. 1 dargestellten Akkumulator sehr ähnlich ist. Anstelle von vier Leitungen L1..L4 sind hier jedoch sieben Leitungen L1..L7, zusätzliche D-Flip-Flops 26a..26n, zusätzliche UND-Gatter 27a..27n, zusätzliche Umschalter 28a..28n und eine abgeänderte zentrale Überwachungseinheit 4, die im Folgenden anhand von Fig. 9 näher erläutert wird, vorhanden.

Fig. 9 zeigt die zentrale Überwachungseinheit 4 aus Fig. 8, welche einen Mikrokontroller 10, drei Komparatoren 11, 14 und 29 zwei Spannungsquellen 15 und 17, zwei Widerstände 18, 19, einen Schalter 20 sowie Dioden 21 umfasst.

Die Funktion des erfindungsgemässen Akkumulators 1 wird nun anhand der Figuren 8 bis 10 näher erläutert. Der Einfachheit halber werden die Erklärungen dabei auf die Unterschiede zu der Funktion des in der Fig. 1 dargestellten Akkumulators 1 beschränkt:

Am Ausgang jeder Zellüberwachungseinheit 3a..3n befindet sich ein Umschalter 28a..28n, mit dem sich der Ausgang eines ausgangsseitigen Optokopplers 6 wahlweise zwischen der vierten Signalleitung L4 und der fünften Signalleitung L5 umschalten lässt. Die Umschalter werden dabei durch die D-Flip-Flops 26a..26n angesteuert.

Durch ein impulsförmiges Reset-Signal auf der Leitung L7 werden alle D-Flip-Flops 26a..26n zurückgesetzt, sodass deren Ausgang Qa..Qn den Wert Null annimmt. Kurz nach Beginn des Referenzpulses auf der Leitung L2 (low aktiv) wird das Reset-Signal auf Hoch (inaktiv) gesetzt; Dadurch wird der Ausgang der Zellüberwachungseinheit 3n auf die fünfte Leitung L5 geschaltet.

Sodann folgt die Messwertübertragung, welche schon anhand der Fig. 4 erläutert wurde. Im Unterschied zu dem zu Fig. 4 erläuterten Ablauf, wird der Messwert der Zellüberwachungseinheit 3n nun aber aus dem Summensignal ausgenommen und stattdessen individuell über die Leitung L5 übertragen.

Mit dem Beginn des nächsten Referenzpulses auf der zweiten Leitung (negative Flanke) wird das D-Flip-flop 26n auf Qn=Hoch gesetzt, Damit wird der Ausgang der Zellüberwachungseinheit 3n wieder von der Leitung L5 getrennt und dem Summensignal L4 zugeschaltet, nun aber der Ausgang der Zellüberwachungseinheit 3n-1 auf die Leitung L5 geschaltet, sodass deren Messwert individuell übermittelt werden kann. Auf diese Weise werden nacheinander alle Zellüberwachungseinheiten 3a..3n einzeln auf die Leitung L5 geschaltet und die Messwerte individuell übertragen. Der gesamte Strang aus den Zellüberwachungseinheit 3a..3n ist durchlaufen, wenn das D-Flip-Flop 26a gesetzt ist (Qa=Hoch). Um die Synchronisation zu gewährleisten wird der Ausgang des D-Flip-Flops 26a über die Leitung L6 zum Mikrocontroller 10 zurückgeführt, damit das Ende eines Messzyklus angezeigt wird. Eine neue Mess-Sequenz kann sodann durch einen neuen Reset-Puls auf der Leitung L7 gestartet werden.

Die Umschalter 28a..28n werden also nacheinander einzeln durch eine Art Schieberegister, welche durch die verketteten D-Flip-Flops 28a..28n gebildet wird, angesteuert, sodass alle PWM-Signale der einzelnen Zellen 2a..2n nacheinander individuell über die Signalleitung L5 übermittelt und ausgewertet werden können. Die UND-Gatter 27a..27n dienen dabei der korrekten Ansteuerung der Umschalter 28a..28n.

Der jeweils über die Leitung L5 übertragene Messwert wird individuell über den Komparator 28 ausgewertet. Durch den Zeitmultiplex ist auch keine spezielle Adressierung der Zellüberwachungseinheiten 3a..3n nötig, beziehungsweise ist durch diesen bewerkstelligt. Da die übrigen Messwerte aber nach wie vor als Summensignal übertragen werden, kann aus dem Summensignal wie gehabt der höchste Messwert innerhalb des Summensignals über den Komparator 11 und der niedrigste Messwert innerhalb des Summensignals über den Komparator 14 ermittelt werden. Im Mikrokontroller 10 kann weiterhin verglichen werden, ob der individuell über die Leitung L5 übertragene Messwert den höchsten Wert aus dem Summensignal überschreitet oder den niedrigsten Wert aus dem Summensignal unterschreitet. Auf diese Weise kann mit einer Messwertübertragung (nicht zu verwechseln mit dem durch die D-Flip-Flops 26a..26n realisierten Messzyklus) ein individueller Messwert einer Zelle 2a..2n, sowie der höchste und der niedrigste Messwert innerhalb des Akkumulators 1 ermittelt werden. Selbstverständlich ist dieses Prinzip der Messwertübertragung nicht auf die Ermittlung von Zellspannungen beschränkt, sondern es können alternativ oder zusätzlich auch andere Zellparameter, beispielsweise die Zelltemperatur, auf diese Weise übertragen werden.

Bei der vorliegenden Variante der Erfindung wird also zeitlich nacheinander jeweils ein Messwert aus der Summierung ausgenommen und individuell an die zentrale Überwachungseinheit 4 übermittelt.

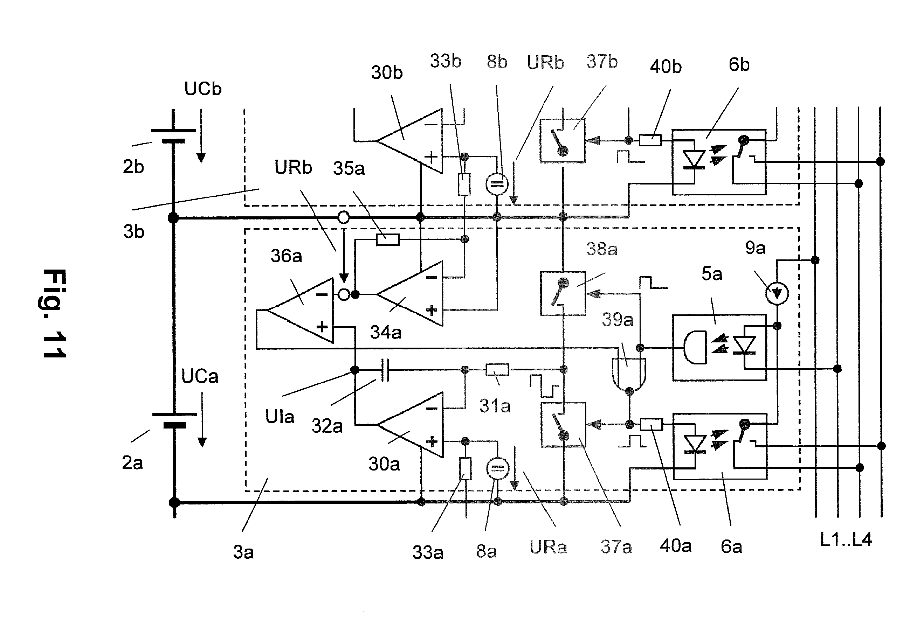

Fig. 11 zeigt nun eine weitere Variante der Erfindung. Dabei ist eine Zellüberwachungseinheit 3a und ausschnittsweise eine Zellüberwachungseinheit 3b (hier nicht wie in den anderen Figuren darunter sondern darüber) dargestellt. Konkret sind in der Fig. 11 Einheiten dargestellt, welche zum Abgleich eines Referenzwertes, hier einer Referenzspannung, vorgesehen sind. Die in den bisherigen Figuren in einer Zellüberwachungseinheit 3a..3n dargestellten Einheiten können in einer realen Ausführungsform einer Zellüberwachungseinheit 3a..3n natürlich zusätzlich vorhanden sein. Das heisst eine Zellüberwachungseinheit 3 kann alle die in den Figuren 2, 6 und 10 gezeigten Einheiten enthalten.

Die Zellüberwachungseinheit 3a umfasst einen eingangsseitigen Optokoppler 5a, einen ausgangsseitigen Optokoppler 6a, eine Referenzquelle 8a (im vorliegenden Fall als Referenzspannungsquelle ausgebildet) und eine Stromquelle 9a. Desweiteren umfasst die Zellüberwachungseinheit 3a einen Operationsverstärker 30a, an dessen positivem Eingang die Referenzspannungsquelle 8a angeschlossen ist, und welcher mit dem Widerstand 31a und dem Kondensator 32a einen Integrator bildet. An den positiven Eingang des Operationsverstärkers 30a ist weiterhin ein Widerstand 33a angeschlossen, welcher für die Verbindung mit einer weiteren Zellüberwachungseinheit vorgesehen ist. Weiterhin umfasst die Zellüberwachungseinheit 3a einen Operationsverstärker 34a, dessen positiver Eingang mit dem Pluspol der Zelle 2a verbunden ist, und welcher gemeinsam mit den Widerständen 35a und 33b einen Summierverstärker bildet. Die Ausgänge der Operationsverstärker 30a und 34a sind mit einem Komparator 36a verbunden. Die Zellüberwachungseinheit 3a umfasst auch einen Schalter 37a, mit dem der Eingang des Integrators an den Minuspol der Zelle 2a geschaltet werden kann, und einen Schalter 38a, mit dem der Eingang des Integrators an den Pluspol der Zelle 2a geschaltet werden kann. Desweiteren umfasst die Zellüberwachungseinheit 3a ein NOR-Gatter 39a, an dessen Eingänge der Ausgang des eingangsseitigen Optokopplers 5a und der Ausgang des Komparators 36a geführt sind. Der Ausgang des NOR-Gatters 39a ist an den Steuereingang des Schalters 37a und über einen Widerstand 40a an den Eingang des ausgangsseitigen Optokopplers 6a geführt.

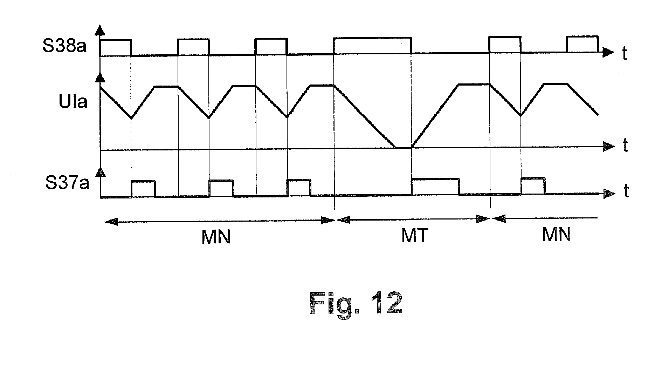

Die Funktion der in der Fig. 11 dargestellten Schaltung wird nun anhand der Fig. 12 erläutert, welche die zeitlichen Verläufe des Eingangssignals S37a des Schalters 37a, des Eingangssignals S38a des Schalters 38a, sowie die Ausgangsspannung des Integrators UIa zeigt. Dabei wird zwischen einem Normalmodus MN und einem Testmodus MT unterschieden.

Während des Normalmodus MN wird die Spannung UCa-URa mit Hilfe des Integrators (Operationsverstärker 30a) während der Referenzzeit T1 (siehe auch Fig. 5) negativ integriert. Dabei ist der Schalter 38a geschlossen, der Schalter 37a offen. Nach Ablauf der Referenzzeit T1 wird der ausgangseitige Optokoppler 6a umgeschaltet und es wird die Referenzspannung URa während der Dauer T2 (siehe ebenfalls Fig. 5) positiv integriert, bis die Komparatorschwelle UCa-URb erreicht ist. Während dieser Zeit ist der Schalter 38a offen, der Schalter 37a geschlossen. Dann wird die Integration gestoppt und das Ausgangssignal wieder inaktiv. Damit ist Komparatorschwelle wieder der Startwert für die nächste Integration, und die Referenzspannung URb geht nicht in den Ausgangs-Pulsdauer T2 ein:

$$T2_{MN} = T1 \cdot \left( \frac{UCa}{URa} - 1 \right)$$

Während des Testmodus MT wird die Spannung UCa-URa mit Hilfe des Integrators während der Referenzzeit T1 wiederum negativ integriert. Dabei ist der Schalter 38a wiederum geschlossen, der Schalter 37a offen. Die Zeit T1 wird dabei aber so gewählt, dass der Ausgang des Operationsverstärkers 30a auch bei minimaler Zellspannung sicher Null erreicht und dort stehen bleibt. Nach Ablauf der Referenzzeit T1 wird der ausgangseitige Optokoppler 6a umgeschaltet und es wird die Referenzspannung URa während der Dauer T2 positiv integriert, bis die Komparatorschwelle UCa-URb wieder erreicht ist. Während dieser Zeit ist der Schalter 38a offen, der Schalter 37a geschlossen. Dann wird die Integration gestoppt und das Ausgangssignal wieder inaktiv. Zeit T2 hängt nun nicht mehr von T1, sondern von Wert des Widerstands 31, der Kapazität des Kondensators 32 und der Referenzspannung URb ab:

$$T2_{MT} = R_{31}C_{32} \cdot \left( \frac{UCa}{URa} - \frac{URb}{URa} \right)$$

ist nun URa ≈ URb, so wird

$$T2_{MT} \approx T2_{MN} \cdot \frac{R_{31}C_{32}}{T1}$$

sofern sich UCa nicht verändert hat. Eine grössere Abweichung von $T2_{MT}$ vom obigen Sollwert deutet darauf hin, dass URa oder URb nicht mehr korrekt ist. Die Werte für C32 können dabei beispielsweise bei der ersten Inbetriebnahme gespeichert werden.

Abschliessend wird angemerkt, dass die aufgezeigten Varianten nur einen Ausschnitt aus den vielen Möglichkeiten für einen erfindungsgemässen Akkumulator 1, eine erfindungsgemässe Zellüberwachungseinheit 3a..3n und eine erfindungsgemässe zentrale Überwachungseinheit 4 darstellen, und nicht dazu herangezogen werden dürfen, den Anwendungsbereich der Erfindung zu limitieren. Für den Fachmann sollte es ein Leichtes sein, die Erfindung basierend auf den hier dargestellten Überlegungen auf seine Bedürfnisse anzupassen, ohne dabei den Schutzbereich der Erfindung zu verlassen. Darüber hinaus wird darauf hingewiesen, dass Teile der in den Figuren dargestellten Vorrichtungen auch die Basis für unabhängige Erfindungen bilden können.

**Bezugszeichenliste**

| 1 | Akkumulator |
|---|---|
| 2, 2a..2n | Zellen |
| 3, 3a..3n | Zellüberwachungseinheit |
| 4 | zentrale Überwachungseinheit |
| 5, 5a | eingangsseitiger Optokoppler |
| 6, 6a, 6b | ausgangsseitiger Optokoppler |
| 7 | Messwertumformer |
| 8, 8a, 8b | Referenzquelle |
| 9, 9a | Stromquelle |
| 10 | Mikrocontroller |
| 11..14 | Komparator |
| 15..17 | Spannungsquelle |
| 18, 19 | Widerstand |
| 20 | Schalter |
| 21 | Dioden |
| 22 | Stellwertumformer |
| 23 | Zellregler |
| 24 | Transistor |
| 25 | Widerstand |
| 26a..26n | D-Flip-Flop |
| 27a..27n | UND-Gatter |
| 28a..28n | Umschalter |
| 29 | Komparator |
| 30a, 30b | Operationsverstärker |
| 31a | Widerstand |
| 32a | Kondensator |
| 33a, 33b | Widerstand |
| 34a | Operationsverstärker |
| 35a | Widerstand |
| 36a | Komparator |
| 37a, 37b | Schalter |

| 38a | Schalter |
|---|---|
| 39a | ODER-Gatter |
| 40a, 40b | Widerstand |
| B | Datenbus |
| IL2..IL3 | Strom durch Leitungen L2..L3 |
| L1..L7 | Signalleitungen |
| MN | Normalmodus |
| MT | Testmodus |
| U11..U14 | Ausgangsspannungen der Komparatoren 11..14 |
| U18, U19 | Spannung an Widerständen 18, 19 |
| UCa, UCb | Zellspannung |
| UIa | Integratorspannung |
| URa, URb | Referenzspannung |

**Patentansprüche**

1. Verfahren zur Überwachung eines Akkumulators (1) mit mehreren Zellen (2, 2a..2n), bei dem ein Parameter einer Zelle (2, 2a..2n) gemessen und an eine zentrale Überwachungseinheit (4) übermittelt wird, **dadurch gekennzeichnet, dass** die Übermittlung des Messwerts mit Hilfe eines pulsweitenmodulierten Signals erfolgt.

2. Verfahren nach Anspruch 1, **dadurch gekennzeichnet, dass** die von den einzelnen Zellen (2, 2a.. 2n) stammenden pulsweitenmodulierten Signale synchron übermittelt und summiert werden.

3. Verfahren nach Anspruch 2, **dadurch gekennzeichnet, dass** eine Stufe in dem durch die Summierung entstandenen treppenförmigen Signal (IL3, IL4) in der zentralen Überwachungseinheit (4) als Messwert einer Zelle (2, 2a..2n) interpretiert und der Messwert (U11..U14) aus dem Summensignal (IL3, IL4) isoliert wird.

4. Verfahren nach Anspruch 3, **dadurch gekennzeichnet, dass** die erste und/oder letzte Stufe in dem durch die Summierung entstandenem treppenförmigen Signal (IL3, IL4) in der zentralen Überwachungseinheit (4) als Extremwert des gemessenen Parameters innerhalb des Akkumulators (1) interpretiert und der Messwert (U11, U14) aus dem Summensignal (IL3, IL4) isoliert wird.

5. Verfahren nach Anspruch 3 oder 4, **dadurch gekennzeichnet, dass** in der zentralen Überwachungseinheit (4) für die Isolation eines Messwertes detektiert wird, ob das treppenförmige Signal (IL3, IL4) einen zwischen zwei Stufen vorgegeben Pegelwert (U15, U16) passiert.

6. Verfahren nach einem der vorgehenden Ansprüche, **dadurch gekennzeichnet, dass** zeitlich nacheinander jeweils ein Messwert individuell an die zentrale Überwachungseinheit (4) übermittelt wird, wobei vorzugsweise
der individuell an die zentrale Überwachungseinheit (4) übermittelte Messwert parallel zum Summensignal (IL3, IL4) übermittelt wird und insbesondere.
der individuell an die zentrale Überwachungseinheit (4) übermittelte Messwert aus der Summierung ausgenommen wird.

7. Verfahren nach einem der vorgehenden Ansprüche, **dadurch gekennzeichnet, dass** als Messwert die Abweichung des Zellparameters von einem je Zelle (2, 2a..2n) vorgesehen Referenzwert herangezogen wird.

8. Verfahren nach einem der vorgehenden Ansprüche, **dadurch gekennzeichnet, dass**

   - für die Erfassung von Messwerten verwendete und je Zelle (2, 2a..2n) vorgesehene Referenzwerte (URa, URb) benachbarter Zellen (2, 2a.. 2n) periodisch wiederkehrend miteinander verglichen werden, und
   - eine Fehlermeldung ausgegeben wird, wenn die Abweichung einen vorgebbaren Grenzwert überschreitet.

9. Verfahren nach einem der vorgehenden Ansprüche, **dadurch gekennzeichnet, dass** als Parameter die Spannung und/oder die Temperatur der Zelle (2, 2a.. 2n) vorgesehen ist, wobei vorzugsweise
die gemessene Spannung und die gemessene Temperatur dazu herangezogen werden, eine mit den Klemmen einer Zelle (2, 2a..2n) verbundene und an die Zelle (2, 2a..2n) thermisch gekoppelte Heizung (23) bei Überschreiten eines Grenzwertes für die Zellspannung oder bei Unterschreiten eines Grenzwertes für die Zelltemperatur zu aktivieren.

10. Zellüberwachungseinheit (3, 3a..3n) zum Überwachen einer Zelle (2, 2a..2n) eines Akkumulators, welche eine Messeinrichtung zur Messung eines Parameters der Zelle (2, 2a..2n) sowie eine Sendeeinrichtung (6) zur Übermittlung des Messwertes umfasst,
**dadurch gekennzeichnet,**

**dass** die Sendeeinrichtung (6) zur Übermittlung des Messwertes mit Hilfe eines pulsweitenmodulierten Signals eingerichtet ist.

11. Zentrale Überwachungseinheit (4) zur Überwachung eines Akkumulators (1) mit mehreren Zellen (2, 2a..2n), umfassend eine Empfangseinrichtung zum Empfang eines Messwertes eines Parameters einer Zelle (2, 2a..2n),
**dadurch gekennzeichnet,**
**dass** die Übermittlung des Messwerts mit Hilfe eines pulsweitenmodulierten Signals erfolgt.

12. Zentrale Überwachungseinheit (4) nach Anspruch 14, **gekennzeichnet durch** Mittel (11..16) zur Erkennung einer Stufe in einem **durch** die Summierung mehrerer pulsweitenmodulierten Signale entstandenen treppenförmigen Signal (IL3, IL4) und **durch** Mittel zur Interpretation dieser Stufe als Messwert einer Zelle (2, 2a..2n) und zur Isolation dieses Messwerts aus dem Summensignal (IL3, IL4).

13. Akkumulator (1) mit mehreren Zellen (2, 2a..2n), **gekennzeichnet durch** eine je Zelle (2, 2a..2n) vorgesehene Zellüberwachungseinheit (3, 3a..3n) nach Anspruch 10.

14. Akkumulator (1) nach Anspruch 16, **gekennzeichnet durch** eine mit den Zellüberwachungseinheiten (3, 3a..3n) verbundene zentrale Überwachungseinheit (4) nach einem der Ansprüche 11 bis 12.

15. Akkumulator (1) nach Anspruch 16 oder 17, **gekennzeichnet durch** eine mit den Klemmen einer Zelle (2, 2a..2n) verbundene und an die Zelle (2, 2a..2n) thermisch gekoppelte Heizung (23), wobei vorzugsweise
Mittel zum Messen einer Zellspannung und einer Zelltemperatur und zum Aktivieren der Heizung (23) bei Überschreiten eines Grenzwertes für die Zellspannung oder bei Unterschreiten eines Grenzwertes für die Zelltemperatur vorgesehen sind.

EP 2 385 604 A1

L1..L4

Fig. 1

13

**Fig. 2**

**Fig. 3**

**Fig. 4**

**Fig. 5**

**Fig. 6**

**Fig. 7**

EP 2 385 604 A1

**Fig. 8**

18

L1 L2 L3 L4  L5 L6 L7

**Fig. 9**

**Fig. 10**

Fig. 11

**Fig. 12**

Europäisches
Patentamt

European
Patent Office

Office européen
des brevets

**EUROPÄISCHER RECHERCHENBERICHT**

Nummer der Anmeldung

EP 10 16 2353

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 6 621 247 B1 (BULLING MARCUS [DE] ET AL) 16. September 2003 (2003-09-16) * Zusammenfassung; Ansprüche 1,2,10-13; Abbildungen 1-3 * * Spalte 3, Zeile 46 - Spalte 8, Zeile 14 * | 1-4,10, 11,13,14 | INV. H02J7/00 G01R31/36 |
| | ----- | | |
| X | EP 1 122 854 A2 (HITACHI LTD [JP]) 8. August 2001 (2001-08-08) * Zusammenfassung; Ansprüche 1,6,9,11; Abbildungen 4-11 * * Seite 7, Absatz 50 - Seite 9, Absatz 68 * | 1,5-15 | |
| | ----- | | |
| A | WO 99/05767 A1 (MINNESOTA MINING & MFG [US]; HYDRO QUEBEC [CA]) 4. Februar 1999 (1999-02-04) * Seite 27, Zeile 30 - Seite 30, Zeile 2; Ansprüche 1-5,12-14; Abbildungen 29-37 * * Seite 37, Zeile 33 - Seite 48, Zeile 10 * | 1-15 | |
| | ----- | | RECHERCHIERTE SACHGEBIETE (IPC) H02J G01R |

Der vorliegende Recherchenbericht wurde für alle Patentansprüche erstellt

| Recherchenort | Abschlußdatum der Recherche | Prüfer |
|---|---|---|
| Den Haag | 5. Januar 2011 | Koutsorodis, Dafni |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

......................................................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 10 16 2353

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

05-01-2011

| Im Recherchenbericht angeführtes Patentdokument | | Datum der Veröffentlichung | Mitglied(er) der Patentfamilie | | Datum der Veröffentlichung |
|---|---|---|---|---|---|
| US 6621247 | B1 | 16-09-2003 | DE | 19921675 A1 | 16-11-2000 |
| | | | WO | 0068700 A2 | 16-11-2000 |
| | | | EP | 1127280 A2 | 29-08-2001 |
| | | | JP | 2002544645 T | 24-12-2002 |
| EP 1122854 | A2 | 08-08-2001 | CA | 2333805 A1 | 07-08-2001 |
| | | | DE | 60130508 T2 | 12-06-2008 |
| | | | JP | 2001224138 A | 17-08-2001 |
| | | | KR | 20010078347 A | 20-08-2001 |
| | | | US | 2001011881 A1 | 09-08-2001 |
| WO 9905767 | A1 | 04-02-1999 | AU | 8584198 A | 16-02-1999 |
| | | | CA | 2297739 A1 | 04-02-1999 |
| | | | DE | 69828169 D1 | 20-01-2005 |
| | | | DE | 69828169 T2 | 15-12-2005 |
| | | | EP | 0998779 A1 | 10-05-2000 |
| | | | JP | 2001511638 T | 14-08-2001 |
| | | | JP | 2008220167 A | 18-09-2008 |
| | | | US | 5952815 A | 14-09-1999 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0814556 A2
- DE 69828169 T2
- WO 2008055505 A1
- WO 2006108081 A2
- US 6873134 B2
- EP 2085784 A2